# FASCICULE DE BREVET EUROPEEN

(11) **EP 3 072 309 B1**
(45) Date de publication et mention de la délivrance du brevet: **02.01.2019**
(21) Numéro de dépôt: 14806008.0
(22) Date de dépôt: 05.11.2014
(51) Int. Cl.: H04Q 9/00, G07C 5/00, G01R 31/00

(54) **INTERFACE DE COMMUNICATION VIRTUELLE POUR DIAGNOSTIC DE VÉHICULE AUTOMOBILE**
VIRTUELLE KOMMUNIKATIONSSCHNITTSTELLE FÜR KRAFTFAHRZEUGDIAGNOSEN
VIRTUAL COMMUNICATION INTERFACE FOR MOTOR VEHICLE DIAGNOSIS

(30) Priorité: 21.11.2013 FR 1361484
(43) Date de publication de la demande: 28.09.2016
(73) Titulaire: PSA Automobiles SA, 78300 Poissy (FR)
(72) Inventeur: JOLY, Thierry, F-92350 Le Plessis Robinson (FR); PINON, Franck, F-78490 Mere (FR); VIF, Jean Francois, F-91700 Ste Geneviève Des Bois (FR)
(74) Mandataire: Jeannin, Laurent Jean-Pierre
(86) Numéro de dépôt international: PCT/FR2014/052808
(87) Numéro de publication internationale: WO 2015/075342

(56) Documents cités:
- GB-A- 2 444 622
- US-A1- 2005 267 655
- US-A1- 2008 312 786
- US-A1- 2013 030 640

## Description

L'invention a trait au domaine du télédiagnostic sur un véhicule automobile et plus particulièrement à la virtualisation d'une Interface de Communication Véhicule ou VCI (Vehicle Communication Interface).

Les véhicules actuels comportent des moyens embarqués d'autodiagnostic ou OBD (On-Board Diagnostics), mis en oeuvre par exemple via des calculateurs embarqués, fournissant des informations relatives aux états des différents systèmes électroniques embarqués dans le véhicule (ex : moteur, système de freinage, habitacle).

Ces informations peuvent être utilisées à des fins de diagnostic par les garagistes ou par les constructeurs automobiles, par exemple lors de l'entretien ou la réparation des véhicules.

Afin de pouvoir accéder à ces informations, une solution courante consiste à connecter une carte de communication physique à l'interface standard de communication véhicule VCI, située entre le véhicule et un outil de diagnostic fourni par le constructeur, tel que le logiciel DiagBox chez PEUGEOT CITROEN.

A titre d'exemple, une carte VCI Pass-Thru, basée sur le standard SAE J2534, peut être utilisée pour une transmission directe de données entre les calculateurs d'un véhicule automobile et un outil de diagnostic constructeur. La carte Pass-Thru est connectée d'une part au véhicule, via une prise OBD, et d'autre part à un terminal embarquant l'outil de diagnostic constructeur via une prise USB.

L'utilisation d'un tel dispositif implique la présence de l'utilisateur de l'outil de diagnostic à proximité du véhicule. Cette situation souffre de divers inconvénients. Elle implique notamment une manipulation physique de la liaison par l'utilisateur, l'utilisation d'une liaison physique en fonction de l'outil de diagnostic, et induit des contraintes spatiales liées au dispositif telles que la place occupée en atelier et l'ergonomie du poste de travail requise.

Afin de remédier aux inconvénients précités, il est tentant de s'affranchir de la liaison physique entre l'outil de diagnostic et le véhicule. Ainsi, plusieurs propositions de diagnostic à distance (télédiagnostic) ont déjà été proposées par le passé.

Ainsi, la demande de brevet américain US 2007/0100519 décrit un système de communication à distance d'un véhicule avec une base de données et un programme de diagnostic. Il est prévu un protocole de communication entre le véhicule et le système distant de diagnostic piloté par un utilisateur.

La demande de brevet français FR 2 799 034 décrit un procédé pour le diagnostic d'un véhicule faisant appel à un système récupérant les données et anomalies du véhicule à tester, qui les envoie via une communication sans fil à un système expert qui peut envoyer des requêtes de diagnostic.

La demande de brevet américain US 2008/0221749 décrit une méthode pour établir un diagnostic via une communication sans fil entre le véhicule et un service de diagnostic qui peut être distant.

La demande de brevet américain US 2006/0095174 décrit un service télématique entre un véhicule et un serveur. Il est prévu des fonctionnalités de télédiagnostic.

La demande de brevet américain US 2007/0093924 décrit une interface pour un utilisateur d'un système de télédiagnostic.

Le document US 2008/0312786 A1 divulgue un système de diagnostic de véhicule utilisant un premier protocole de communication de données dans l'environnement du véhicule et un deuxième protocole de communication de données, sans-fil, pour fournir les données à un système distant du véhicule. Un outil permet d'encapsuler les données du véhicule selon le premier protocole de communication pour les transmettre par une liaison sans fil vers le système déporté.

Ces solutions reposent cependant sur des outils de téléphonie mobile (GSM, SMS) ou satellitaire, qui doivent donc être intégrées dans les systèmes de diagnostic. De plus, ces solutions proposées sont dépendantes des modes de transmissions envisagés. Ainsi, chaque solution de télédiagnostic proposée nécessite la reconstruction du système de diagnostic dans son ensemble, c'est-à-dire aussi bien de l'outil de diagnostic, des outils associés au mode de communication choisi, ainsi que des moyens de communications embarqués dans le véhicule.

Un premier objectif est de remédier aux inconvénients précités, tout en répondant aux contraintes fonctionnelles.

Un deuxième objectif est de proposer une solution indépendante de l'outil de diagnostic et du mode de communication utilisé avec un véhicule.

Un troisième objectif est de s'affranchir de l'interface physique de communication entre un outil de diagnostic et un véhicule.

Un quatrième objectif est de rendre possible une communication sans fil distante entre un outil de diagnostic quelconque et un véhicule.

Il est proposé, selon un premier aspect, un système de diagnostic d'un véhicule automobile équipé d'un premier module de communication sans fil configuré pour réceptionner une requête de diagnostic selon un premier protocole de communication, ce système de diagnostic comprenant :
- un outil de diagnostic configuré pour émettre une requête de diagnostic à destination du véhicule automobile selon un deuxième protocole de communication ;
- un deuxième module de communication sans fil, configuré pour transmettre la requête de diagnostic émise par l'outil de diagnostic selon le deuxième protocole de communication, via un réseau sans fil de communication au premier module de communication sans fil équipant le véhicule automobile ;
- un module logiciel interfacé entre l'outil de diagnostic et le deuxième module de communication sans fil, ce module logiciel étant configuré pour
   - intercepter la requête de diagnostic émise par l'outil de diagnostic selon le deuxième protocole de communication ;
   - encapsuler la requête de diagnostic interceptée dans une trame selon le premier protocole de communication ;
   - transférer la trame encapsulant la requête de diagnostic au deuxième module de communication sans fil selon le premier protocole de communication.

Avantageusement, dans ce système de diagnostic, le deuxième module de communication sans fil est configuré pour réceptionner une trame selon le premier protocole, la trame encapsulant une réponse à la requête de diagnostic, le module logiciel étant en outre configuré pour
- intercepter la trame encapsulant la réponse à la requête de diagnostic selon le premier protocole de communication ;
- décapsuler la trame encapsulant la réponse à la requête de diagnostic selon le premier protocole de communication ;
- transférer la réponse à la requête de diagnostic à l'outil de diagnostic.

Avantageusement, dans ce système de diagnostic, le premier protocole de communication est un protocole TCP/IP.

Avantageusement, dans ce système de diagnostic, le deuxième protocole de communication est un protocole CAN.

Il est proposé, selon un deuxième aspect, un terminal utilisateur comprenant le système précédemment décrit.

Il est proposé, selon un troisième aspect, une méthode de diagnostic d'un véhicule automobile équipé d'un premier module de communication sans fil configuré pour réceptionner une requête de diagnostic selon un premier protocole de communication, cette méthode de diagnostic comprenant :
- une étape d'émission d'une requête de diagnostic à destination du véhicule automobile par un outil de diagnostic selon un deuxième protocole de communication ;
- une étape d'interception de la requête de diagnostic émise par l'outil de diagnostic selon le deuxième protocole de communication, par un module logiciel interfacé entre l'outil de diagnostic et un deuxième module de communication sans fil, le deuxième module de communication sans fil étant configuré pour transmettre la requête de diagnostic émise selon le deuxième protocole de communication par l'outil de diagnostic, via un réseau sans fil de communication au premier module de communication sans fil équipant le véhicule automobile ;
- une étape d'encapsulation la requête de diagnostic interceptée dans une trame selon le premier protocole de communication par le module logiciel ;
- une étape de transfert de la trame encapsulant la requête de diagnostic par le module logiciel au deuxième module de communication sans fil selon le premier protocole de communication.

Avantageusement, cette méthode de diagnostic, comprend en outre :
- une étape de réception par le deuxième module de communication d'une trame selon le premier protocole de communication, la trame encapsulant une réponse à la requête de diagnostic ;
- une étape d'interception par le module logiciel de la trame encapsulant la réponse à la requête de diagnostic selon le premier protocole de communication ;
- une étape de décapsulation par le module logiciel selon le premier protocole de communication de la trame encapsulant la réponse à la requête de diagnostic ;
- une étape de transfert par le module logiciel de la réponse à la requête à l'outil de diagnostic.

Avantageusement, dans cette méthode de diagnostic, le premier protocole de communication est un protocole TCP/IP.

Avantageusement, dans cette méthode de diagnostic, le deuxième protocole de communication est un protocole CAN.

Il est proposé, selon un quatrième aspect, un produit programme d'ordinateur implémenté sur un support mémoire, susceptible d'être mis en oeuvre au sein d'une unité de traitement informatique et comprenant des instructions pour la mise en oeuvre de la méthode résumée ci-dessus.

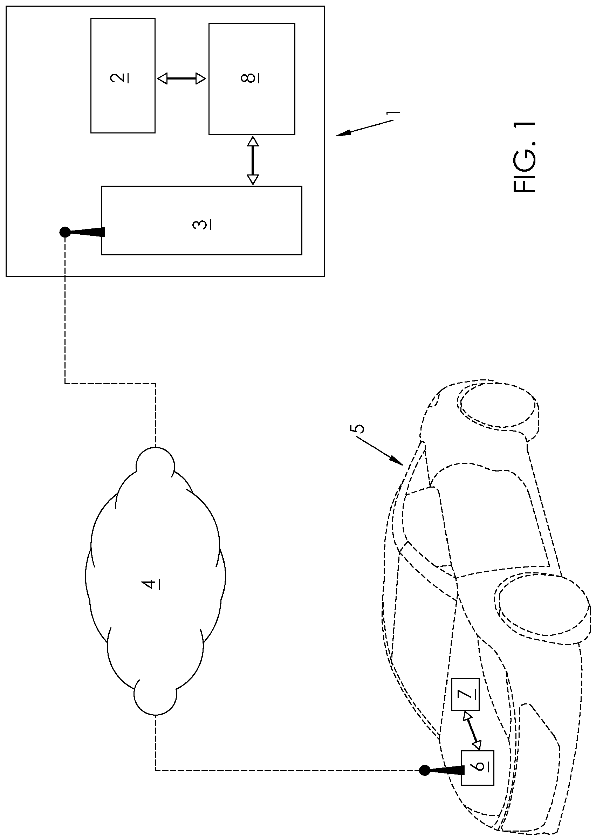

D'autres caractéristiques et avantages de l'invention apparaîtront plus clairement et de manière concrète à la lecture de la description ci-après de modes de réalisation préférés, laquelle est faite en référence à la figure 1, qui illustre un mode de réalisation.

Afin de remédier aux contraintes engendrées par une liaison physique, il est, ici, proposé de faire communiquer un outil de diagnostic et un véhicule automobile sans passer par une interface VCI. Pour cela, une interface virtuelle VVCI (Virtual VCI) est mise en oeuvre.

En référence à la figure 1, dans un mode de réalisation, un terminal 1 utilisateur comprend un outil de diagnostic 2 automobile, tel que le logiciel DiagBox.

On désigne, ici, par terminal 1 utilisateur, tout dispositif utilisateur bénéficiant d'un ou plusieurs moyens d'affichage de données relatives à un outil de diagnostic 2 automobile embarqué et comprenant au moins un module de communication 3 sans fil (par exemple une carte réseau compatible Wifi, Bluetooth, ou cellulaire), permettant l'échange de données au travers au moins un réseau 4 de communication sans fil (fixe ou mobile), avec au moins un véhicule 5 automobile distant. A titre d'exemple, le terminal 1 utilisateur peut être un ordinateur fixe ou portable, un smartphone ou une tablette.

Un véhicule 5 automobile distant comprend aussi au moins un module de communication 6 sans fil compatible avec le module de communication 3 sans fil du terminal 1 utilisateur, c'est-à-dire permettant la communication avec le terminal **1** utilisateur à travers un réseau **4** sans fil de communication. A titre d'exemple non-limitatif, le réseau **4** sans fil de communication, peut être un réseau Wifi, Bluetooth, 3G ou plus généralement un réseau IP sans fil.

Le véhicule **5** automobile comprend, de plus, au moins un calculateur **7** embarqué capable d'échanger des informations avec au moins le module de communication **6** sans fil. A titre d'exemple, le calculateur **7** embarqué est une unité de commande électronique (ECU) capable de communiquer des informations de diagnostics d'un système électronique du véhicule **5** automobile à un module de communication **6** sans fil.

Le terminal **1** utilisateur comprend quant à lui un module **8** logiciel interfacé (c'est-à-dire comportant des interfaces connectées, assurant la liaison) entre l'outil de diagnostic **2** et le module de communication **3** sans fil. Le module **8** logiciel reproduit de manière virtuelle le comportement réel d'une interface physique VCI. Le module **8** logiciel prend en charge les paramètres, fonctions et protocoles de communication d'une carte de communication Pass-Thru, tels que définis par le standard SAE J2534.

Ainsi, le module **8** logiciel peut éventuellement être interprété comme une carte physique Pass-Thru virtualisée. Le module **8** logiciel fonctionne en arrière plan par rapport à l'outil de diagnostic **2.** En fait, le module **8** logiciel est configuré pour implémenter un processus en écoute permanente de deux ports de communication prédéfinis/identifiés, respectivement au niveau de l'outil de diagnostic **2** et au niveau du module **3** de communication sans fil. D'un point de vue utilisateur, l'ensemble des opérations gérées par le module **8** logiciel s'effectue de manière totalement transparente.

Suivant un mode de réalisation préféré, un utilisateur effectue une requête de diagnostic à destination d'au moins un calculateur **7** embarqué dans un véhicule **5** automobile distant. La requête est effectuée via un outil de diagnostic **2.** L'outil de diagnostic **2** émet la requête utilisateur, sous la forme d'une trame-requête, selon un premier protocole de communication. Par exemple, une trame selon le protocole CAN à destination d'au moins un calculateur **7** embarqué, est émise par l'outil de diagnostic **2,** via un premier port de communication prédéfini. Le module **8** logiciel intercepte, au niveau de ce premier port de communication, la trame-requête associée à la requête de diagnostic utilisateur. Par « intercepter » une trame, on entend ici que le module **8** logiciel récupère, de manière transparente vis-à-vis de l'outil **2** de diagnostic et du module **3** de communication sans fil, une trame n'étant pas supposée avoir pour destination ce module **8** logiciel.

Le module **8** logiciel effectue alors une encapsulation de la trame-requête, selon un deuxième protocole de communication prédéfini. Par exemple, le module **8** logiciel encapsule la trame-requête sous forme TCP/IP dans une trame Ethernet, selon une méthode connue de l'état de l'art. Le module **8** logiciel transfère ensuite la trame encapsulée sur un deuxième port de communication prédéfini, au niveau du module **3** de communication sans fil pour émission.

Le module **3** de communication sans fil, transmet ensuite via le réseau **4** de communication sans fil la trame-requête encapsulée à une adresse IP prédéterminée du véhicule **5** automobile distant. L'adresse IP prédéterminée correspond, par exemple, à un module **6** de communication sans fil spécifique, configuré pour échanger des informations avec au moins un calculateur **7** embarqué.

A réception de la trame encapsulée, le module **6** de communication sans fil décapsule celle-ci, selon le deuxième protocole de communication prédéfini. Le module **6** de communication sans fil envoie alors la requête de diagnostic, par exemple une trame selon le protocole de communication CAN (Controller Area Network), au calculateur **7** embarqué concerné. Le calculateur **7** embarqué, génère en réponse à la requête de diagnostic, une trame-réponse selon le même premier protocole de communication (ex : trame CAN).

Le calculateur **7** embarqué envoie ensuite ladite trame-réponse, au module **6** de communication sans fil pour encapsulation. Le module **6** de communication sans fil effectue l'encapsulation selon le deuxième protocole de communication prédéfini, par exemple sous forme TCP/IP dans une trame Ethernet. La trame-réponse encapsulée, est ensuite transmise à destination terminal utilisateur **1,** par le module de communication **6** via le réseau **4** sans fil de communication. La trame-réponse encapsulée, est réceptionnée par le module **3** de communication sans fil du terminal **1** utilisateur. La réception s'effectue au niveau du port utilisé lors de l'émission, c'est-à-dire du deuxième port de communication. Dès la réception de la trame-réponse encapsulée, le module **8** logiciel intercepte puis décapsule celle-ci selon le deuxième protocole de communication. Le module **8** logiciel transfère alors la trame-réponse générée (par le calculateur **7** embarqué) selon le premier protocole de communication, par exemple une trame CAN, à l'outil **2** de diagnostic sur le premier port de communication.

Suite à la réception de la trame-réponse sur le premier port de communication, l'outil **2** de diagnostic peut alors afficher les informations correspondant à la réponse de la requête de diagnostic. En pratique, quel que soit le statut d'une requête utilisateur (en cours de transmission, en attente de réponse, traitée), le module **8** logiciel reste en écoute permanente à la fois du premier port de communication dans l'attente d'intercepter d'éventuelles nouvelles requêtes de diagnostic, et du deuxième port de communication en vue d'intercepter une réponse à une requête de diagnostic spécifique, à transférer à l'outil **2** de diagnostic.

Avantageusement, toutes les opérations effectuées par le module logiciel **8** sont totalement transparentes vis-à-vis de l'outil **2** de diagnostic **2,** la trame-réponse fournie à l'outil **2** de diagnostic par le module **8** logiciel étant interprétée par l'outil **2** de diagnostic comme une réponse provenant directement du calculateur auquel une requête a été envoyée.

Avantageusement, l'utilisation du module **8** logiciel permet de s'affranchir des contraintes temporelles imposées par les outils de diagnostics ou liaisons physiques existants (temps de transmissions, réception, « timeouts »). Ainsi, dans un mode de réalisation, le module **8** logiciel gère seul les différentes contraintes temporelles. A titre d'exemple, le niveau d'abstraction du module **8** logiciel permet de faire patienter l'outil **2** de diagnostic tant qu'une réponse attendue d'un calculateur n'a pas encore été reçue, et de gérer les délais d'expiration d'un requête ou encore l'absence d'une réponse de la part d'un calculateur **7** embarqué.

Avantageusement, le module **8** logiciel implémente l'ensemble des caractéristiques techniques d'une interface standard VCI, telles que définies par le standard J2534. Le respect de ce standard permet en effet, de garantir la compatibilité du module **8** logiciel avec n'importe quel outil **2** de diagnostic supportant la norme Pass-Thru, en se faisant reconnaître comme une carte de communication physique Pass-Thru standard. Chaque outil de diagnostic spécifique ne nécessite donc plus une carte de communication Pass-Thru spécifique. De même, l'utilisation du module **8** logiciel ne nécessite aucune modification au niveau de l'outil de diagnostic utilisé. Il est entendu que le standard J2534 est, ici, cité à titre d'exemple non-limitatif, le module logiciel **8** pouvant en effet implémenter toute autre norme supportée par une carte de communication physique.

Le fait de s'affranchir d'une carte de communication physique Pass-Thru et d'utiliser un outil de diagnostic **2** à distance, permet :
- de s'affranchir des contraintes engendrées par l'utlisation d'une liaison physique (par ex. : ergonomie du poste de travail, manipulation de la liaison par l'utilisateur) ;
- de pouvoir dialoguer avec n'importe quel élément communicant dans le véhicule **5** et d'obtenir des informations de diagnostic, tant que celui-ci dispose de moyens configurés pour échanger des informations avec un ou plusieurs calculateurs embarqués concernés par une requête de diagnostic. Ainsi, en fonction des scénarios envisagés, il est possible de requérir directement les informations aussi bien d'un (ou plusieurs) calculateur particulier que d'un calculateur central.

## Revendications

1. Système de diagnostic de véhicule (**5**) automobile équipé d'un premier module (**6**) de communication sans fil configuré pour réceptionner une requête de diagnostic selon un premier protocole de communication, ce système de diagnostic comprenant
- un outil (**2**) de diagnostic configuré pour émettre une requête de diagnostic à destination du véhicule (**5**) automobile selon un deuxième protocole de communication ;
- un deuxième module (**3**) de communication sans fil, configuré pour transmettre la requête de diagnostic émise par l'outil (**2**) de diagnostic selon le deuxième protocole de communication, via un réseau (**4**) sans fil de communication au premier module (**6**) de communication sans fil équipant le véhicule (**5**) automobile ;
le système de diagnostic étant **caractérisé en ce qu'**il comprend un module (**8**) logiciel interfacé entre l'outil (**2**) de diagnostic et le deuxième module (**3**) de communication sans fil, ce module (**8**) logiciel étant configuré pour :
- intercepter la requête de diagnostic émise par l'outil (**2**) de diagnostic selon le deuxième protocole de communication ;
- encapsuler la requête de diagnostic interceptée dans une trame selon le premier protocole de communication ;
- transférer la trame encapsulant la requête de diagnostic au deuxième module (**3**) de communication sans fil selon le premier protocole de communication.

2. Système de diagnostic selon la revendication 1, dans lequel le deuxième module (**3**) de communication sans fil est configuré en outre pour réceptionner une trame selon le premier protocole, la trame encapsulant une réponse à la requête de diagnostic, ledit système de diagnostic étant de plus **caractérisé en ce que** le module (**8**) logiciel est configuré pour :
- intercepter la trame encapsulant la réponse à la requête de diagnostic selon le premier protocole de communication ;
- décapsuler la trame encapsulant la réponse à la requête de diagnostic selon le premier protocole de communication ;
- transférer la réponse à la requête de diagnostic à l'outil (2) de diagnostic.

3. Système selon la revendication 1 ou 2, dans lequel le premier protocole de communication est un protocole TCP/IP.

4. Système selon l'une quelconque des revendications 1 à 3, dans lequel le deuxième protocole de communication est un protocole CAN.

5. Terminal (**1**) utilisateur intégrant un système selon l'une quelconque des revendications 1 à 4.

6. Méthode de diagnostic d'un véhicule (**5**) automobile équipé d'un premier module de communication (**6**) sans fil configuré pour réceptionner une requête de diagnostic selon un premier protocole de communication, cette méthode de diagnostic comprenant une étape d'émission d'une requête de diagnostic à destination du véhicule (**5**) automobile par un outil (**2**) de diagnostic selon un deuxième protocole de communication ;
cette méthode de diagnostic étant **caractérisée en ce qu'**elle comprend
- une étape d'interception de la requête de diagnostic émise par l'outil de diagnostic (**2**) selon le deuxième protocole de communication, par un module logiciel (**8**) interfacé entre l'outil de diagnostic (**2**) et un deuxième module de communication (**3**) sans fil, le deuxième module de communication (**3**) sans fil étant configuré pour transmettre la requête de diagnostic émise selon le deuxième protocole de communication par l'outil de diagnostic (**2**), via un réseau (**4**) sans fil de communication au premier module de communication (**6**) sans fil équipant le véhicule (**5**) automobile ;
- une étape d'encapsulation la requête de diagnostic interceptée dans une trame selon le premier protocole de communication par le module logiciel (**8**) ;
- une étape de transfert de la trame encapsulant la requête de diagnostic par le module logiciel (**8**) au deuxième module de communication (**3**) sans fil selon le premier protocole de communication.

7. Méthode de diagnostic selon la revendication 6, comprenant en outre :
- une étape de réception par le deuxième module (**3**) de communication d'une trame selon le premier protocole de communication, la trame encapsulant une réponse à la requête de diagnostic ;
- une étape d'interception par le module (**8**) logiciel de la trame encapsulant la réponse à la requête de diagnostic selon le premier protocole de communication ;
- une étape de décapsulation par le module (**8**) logiciel selon le premier protocole de communication de la trame encapsulant la réponse à la requête de diagnostic ;
- une étape de transfert par le module (**8**) logiciel de la réponse à la requête à l'outil de diagnostic (**2**).

8. Méthode selon la revendication 6 ou la revendication 7, dans laquelle le premier protocole de communication est un protocole TCP/IP.

9. Méthode selon l'une quelconque des revendications 6 à 8, dans laquelle le deuxième protocole de communication est un protocole CAN.

10. Produit programme d'ordinateur implémenté sur un support mémoire, susceptible d'être mis en oeuvre au sein d'une unité de traitement informatique et comprenant des instructions pour la mise en oeuvre de la méthode selon l'une des revendications 6 à 9.

## Patentansprüche

1. Kraftfahrzeugdiagnosesystem (5), das mit einem ersten drahtlosen Kommunikationsmodul (6) ausgestattet ist, das konfiguriert ist, um eine Diagnoseanfrage gemäß einem ersten Kommunikationsprotokoll zu empfangen, wobei dieses Diagnosesystem Folgendes umfasst:
- ein Diagnosetool (2), das konfiguriert ist, um eine Diagnoseanfrage zu dem Kraftfahrzeug (5) gemäß einem zweiten Kommunikationsprotokoll zu senden;
- ein zweites drahtloses Kommunikationsmodul (3), das konfiguriert ist, um die Diagnoseanfrage, die von dem Diagnosetool (2) gemäß dem zweiten Kommunikationsprotokoll ausgegeben wird, über ein drahtloses Kommunikationsnetzwerk (4) zu dem ersten drahtlosen Kommunikationsmodul (6), das das Kraftfahrzeug(5) ausstattet, zu übertragen;
Diagnosesystem **dadurch gekennzeichnet, dass** es ein Softwaremodul (8) als Schnittstelle zwischen dem Diagnosetool (2) und dem zweiten drahtlosen Kommunikationsnetzwerk (3) umfasst, wobei dieses Softwaremodul (8) konfiguriert ist, um:
- die Diagnoseanfrage, die von dem Diagnosetool (2) gemäß dem zweiten Kommunikationsprotokoll ausgegeben wurde, abzufangen,
- die abgefangene Diagnoseanfrage in einem Raster gemäß dem Kommunikationsprotokoll zu kapseln,
- das Raster, das die Diagnoseanfrage kapselt, zu dem zweiten drahtlosen Kommunikationsmodul (3) gemäß dem ersten Kommunikationsprotokoll zu übertragen.

2. Diagnosesystem nach Anspruch 1, wobei das zweite drahtlose Kommunikationsmodul (3) außerdem konfiguriert ist, um ein Raster gemäß dem ersten Protokoll zu empfangen, wobei das Raster eine Antwort auf die Diagnoseanfrage kapselt, wobei das Diagnosesystem außerdem **dadurch gekennzeichnet ist, dass** das Softwaremodul (8) konfiguriert ist, um:
- das Raster, das die Antwort auf die Diagnoseanfrage gemäß dem ersten Kommunikationsprotokoll kapselt, abzufangen;
- das Raster, das die Antwort auf die Diagnoseanfrage gemäß dem ersten Kommunikationsprotokoll kapselt, zu entkapseln;
- die Antwort auf die Diagnoseanfrage zu dem Diagnosetool (2) zu übertragen.

3. System nach Anspruch 1 oder 2, wobei das erste Kommunikationsprotokoll ein TCP/IP-Protokoll ist.

4. System nach einem der Ansprüche 1 bis 3, wobei das zweite Kommunikationsprotokoll ein CAN-Protokoll ist.

5. Benutzerendgerät (1), das ein System nach einem der Ansprüche 1 bis 4 integriert.

6. Diagnoseverfahren eines Kraftfahrzeugs (5), das mit einem ersten drahtlosen Kommunikationsmodul (6) ausgestattet ist, das konfiguriert ist, um eine Diagnoseanfrage gemäß einem ersten Kommunikationsprotokoll zu empfangen, wobei dieses Diagnoseverfahren einen Schritt des Sendens einer Diagnoseanfrage zu dem Kraftfahrzeug (5) durch ein Diagnosetool (2) nach einem zweiten Kommunikationsprotokoll umfasst;
Diagnoseverfahren **dadurch gekennzeichnet, dass** es Folgendes umfasst
- einen Abfangschritt der Diagnoseanfrage, die von dem Diagnosetool (2) gemäß dem zweiten Kommunikationsprotokoll gesendet wird, durch ein Softwaremodul (8), das zwischen dem Diagnosetool (2) und einem zweiten drahtlosen Kommunikationsmodul (3) eine Schnittstelle bildet, wobei das zweite drahtlose Kommunikationsprotokoll (3) konfiguriert ist, um die Diagnoseanfrage, die gemäß dem zweiten Kommunikationsprotokoll von dem Diagnosetool (2) gesendet wird, über ein drahtloses Kommunikationsnetzwerk (4) zu dem ersten drahtlosen Kommunikationsmodul (6), das das Kraftfahrzeug (5) ausstattet, zu übertragen;
- einen Schritt des Kapseln der abgefangenen Diagnoseanfrage in einem Raster gemäß dem ersten Kommunikationsprotokoll durch das Softwaremodul (8) ;
- einen Schritt des Übertragens des Rasters, das die Diagnoseanfrage kapselt, durch das Softwaremodul (8) zu dem zweiten drahtlosen Kommunikationsmodul (3) gemäß dem ersten Kommunikationsprotokoll.

7. Diagnoseverfahren nach Anspruch 6, das außerdem Folgendes umfasst:
- einen Empfangsschritt durch das zweite Kommunikationsmodul (3) eines Rasters gemäß dem ersten Kommunikationsprotokoll, wobei das Raster eine Antwort auf die Diagnoseanfrage kapselt;
- einen Abfangschritt durch das Softwaremodul (8) des Rasters, das die Antwort auf die Diagnoseanfrage gemäß dem ersten Kommunikationsprotokoll kapselt;
- einen Entkapselungsschritt durch das Softwaremodul (8) gemäß dem ersten Kommunikationsprotokoll des Rasters, das die Antwort auf die Diagnoseanfrage kapselt;
- einen Transferschritt durch das Softwaremodul (8) der Antwort auf die Anfrage zu dem Diagnosetool (2) .

8. Verfahren nach Anspruch 6 oder Anspruch 7, wobei das erste Kommunikationsprotokoll ein TCP/IP-Protokoll ist.

9. Verfahren nach einem der Ansprüche 6 bis 8, wobei das zweite Kommunikationsprotokoll ein CAN-Protokoll ist.

10. Computerprogrammprodukt, das auf einem Speicherträger umgesetzt wird, das innerhalb einer Datenverarbeitungseinheit umgesetzt werden kann und Anweisungen für das Anwenden des Verfahrens nach einem der Ansprüche 6 bis 9 umfasst.

## Claims

1. A motor vehicle (5) diagnosis system equipped with a first wireless communication module (6) configured to receive a diagnosis request according to a first communication protocol, this diagnosis system including
- a diagnosis tool (2) configured to emit a diagnosis request to the motor vehicle (5) according to a second communication protocol;
- a second wireless communication module (3), configured to transmit the diagnosis request emitted by the diagnosis tool (2) according to the second communication protocol, via a wireless communication network (4) to the first wireless communication module (6) equipping the motor vehicle (5);
the diagnosis system being **characterized in that** it includes a software module (8) interfaced between the diagnosis tool (2) and the second wireless communication module (3), this software module (8) being configured for:
- intercepting the diagnosis request emitted by the diagnosis tool (2) according to the second communication protocol;
- encapsulating the intercepted diagnosis request in a frame according to the first communication protocol;
- transferring the frame encapsulating the diagnosis request to the second wireless communication module (3) according to the first communication protocol.

2. The diagnosis system according to Claim 1, in which the second wireless communication module (3) is further configured for receiving a frame according to the first protocol, the frame encapsulating a response to the diagnosis request, said diagnosis system being in addition **characterized in that** the software module (8) is configured for:
- intercepting the frame encapsulating the response to the diagnosis request according to the first communication protocol;
- decapsulating the frame encapsulating the response to the diagnosis request according to the first communication protocol;
- transferring the response to the diagnosis request to the diagnosis tool (2).

3. The system according to Claim 1 or 2, in which the first communication protocol is a TCP/IP protocol.

4. The system according to any one of Claims 1 to 3, in which the second communication protocol is a CAN protocol.

5. A user terminal (1) integrating a system according to any one of Claims 1 to 4.

6. A diagnosis method of a motor vehicle (5), equipped with a first wireless communication module (6) configured to receive a diagnosis request according to a first communication protocol, this diagnosis method including an emission step of a diagnosis request to the motor vehicle (5) by a diagnosis tool (2) according to a second communication protocol;
this diagnosis method being **characterized in that** it includes
- an interception step of the diagnosis request emitted by the diagnosis tool (2) according to the second communication protocol, by a software module (8) interfaced between the diagnosis tool (2) and a second wireless communication module (3), the second wireless communication module (3) being configured to transmit the diagnosis request emitted according to the second communication protocol by the diagnosis tool (2), via a wireless communication network (4) to the first wireless communication module (6) equipping the motor vehicle (5);
- a step of encapsulation of the diagnosis request intercepted in a frame according to the first communication protocol by the software module (8) ;
- a transfer step of the frame encapsulating the diagnosis request by the software module (8) to the second wireless communication module (3) according to the first communication protocol.

7. The diagnosis method according to Claim 6, further including:
- a reception step by the second communication module (3) of a frame according to the first communication protocol, the frame encapsulating a response to the diagnosis request;
- an interception step by the software module (8) of the frame encapsulating the response to the diagnosis request according to the first communication protocol;
- a decapsulation step by the software module (8) according to the first communication protocol of the frame encapsulating the response to the diagnosis request;
- a transfer step by the software module (8) of the response to the request to the diagnosis tool (2) .

8. The method according to Claim 6 or Claim 7, in which the first communication protocol is a TCP/IP protocol.

9. The method according to any one of Claims 6 to 8, in which the second communication protocol is a CAN protocol.

10. A computer program product implemented on a memory medium, capable of being implemented within a data processing unit and including instructions for the implementation of the method according to one of Claims 6 to 9.
